# EUROPÄISCHE PATENTSCHRIFT

(11) **EP 3 891 941 B1**
(45) Veröffentlichungstag und Bekanntmachung des Hinweises auf die Patenterteilung: **10.09.2025**
(21) Anmeldenummer: 19816303.2
(22) Anmeldetag: 05.12.2019
(51) Int. Cl.: H04L 12/44, H05K 5/00, G05B 19/042, H04L 45/745

(54) **MODULARES ELEKTRONISCHES STEUERGERÄT FÜR EIN KRAFTFAHRZEUG SOWIE KRAFTFAHRZEUG MIT EINEM SOLCHEN STEUERGERÄT UND RECHENMODULEINHEIT FÜR DAS STEUERGERÄT**
MODULAR ELECTRONIC CONTROL UNIT FOR A MOTOR VEHICLE, AND MOTOR VEHICLE HAVING SUCH A CONTROL UNIT AND COMPUTING MODULE UNIT FOR THE CONTROL UNIT
APPAREIL DE COMMANDE ÉLECTRONIQUE MODULAIRE POUR UN VÉHICULE AUTOMOBILE, ET VÉHICULE AUTOMOBILE ÉQUIPÉ D'UN TEL APPAREIL DE COMMANDE ET MODULE DE CALCUL POUR L'UNITÉ DE COMMANDE

(30) Priorität: 06.12.2018 DE 102018131134
(43) Veröffentlichungstag der Anmeldung: 13.10.2021
(73) Patentinhaber: Bayerische Motoren Werke Aktiengesellschaft, 80809 München (DE)
(72) Erfinder: STRIEBEL, Reiner, 78479 Reichenau (DE); LAENGST, Wolfgang, 85232 Bergkirchen (DE)
(86) Internationale Anmeldenummer: PCT/EP2019/083771
(87) Internationale Veröffentlichungsnummer: WO 2020/115182

(56) Entgegenhaltungen:
- DE-A1- 10 159 480
- DE-A1- 102005 010 476
- DE-A1- 102014 219 469
- DE-B3- 102004 022 614

## Beschreibung

Die Erfindung betrifft ein elektronisches Steuergerät für ein Kraftfahrzeug. Das Steuergerät weist eine Kommunikationseinheit auf, mittels welcher das Steuergerät Kommunikationsdaten mit zumindest einer geräteexternen Fahrzeugkomponente, also beispielsweise einem anderen Steuergerät, austauschen kann. Zu der Erfindung gehören auch ein Kraftfahrzeug mit einem solchen Steuergerät sowie eine Rechenmoduleinheit, die als Bestandteil des Steuergeräts vorgesehen werden kann.

Um in einem Kraftfahrzeug eine Fahrzeugfunktion, beispielsweise eine Fahrfunktion für das autonome Fahren, bereitzustellen, kann vorgesehen sein, diese Fahrzeugfunktion auf der Grundlage eines Steuergeräts zu realisieren. Ein solches Steuergerät kann zumindest ein Prozessorsystem aufweisen, das in einem Gehäuse zusammen mit einem geeigneten Netzteil für die Spannungsversorgung und einer Kühleinrichtung zum Abführen von Abwärme bereitgestellt werden kann. Mittels einer Betriebssoftware für das zumindest eine Prozessorsystem wird dann die gewünschte Fahrzeugfunktion implementiert, sodass beim Betrieb des Steuergeräts, wenn die Betriebssoftware ausgeführt wird, hierdurch in dem Kraftfahrzeug die Fahrzeugfunktion vorhanden ist. Mit einem "Prozessorsystem" ist eine Schaltungsplatine mit zumindest einem Mikroprozessor und der für den Betrieb des zumindest einen Mikroprozessors notwendigen Prozessorperipherie, beispielsweise einem Arbeitsspeicher (RAM - Random Access Memory), gemeint.

Damit es im Betrieb des Steuergeräts nicht zu einer Überlastung des zumindest einen Prozessorsystems kommt, ist die Rechenleistung des zumindest einen Prozessorsystems derart auszulegen, dass alle Rechenschritte, die beim Ausführen der Betriebssoftware anfallen, rechtzeitig ausgeführt werden können, um die an die Fahrzeugfunktion gestellten Anforderungen zu erfüllen. Genauso ist es auch notwendig, das Netzteil und die Kühleinrichtung für das zumindest eine Prozessorsystem geeignet zu dimensionieren, damit das zumindest eine Prozessorsystem stabil laufen kann.

Beim Implementieren einer Fahrzeugfunktion wird also eine Rechenleistung durch Wahl und/oder Dimensionierung des zumindest einen Prozessorsystems festgelegt und die Kühleinrichtung und/oder die Stromversorgung durch das Netzteil wird dann entsprechend darauf dimensioniert.

Bei einer Fahrzeugfunktion, wie insbesondere dem autonomen Fahrbetrieb, kann es allerdings vorkommen, dass bei der Entwicklung nicht bekannt ist, wie viel Rechenleistung die Fahrfunktion letztendlich benötigt wird, weil sich während der Entwicklung herausstellt, dass noch zusätzliche Funktionen nötig sind. Zudem kann man daran interessiert sein, die Fahrzeugfunktion weiter zu entwickeln, wodurch dann auch der Bedarf an Rechenleistung steigen kann. Steht dann eine neue Version einer Fahrzeugfunktion bereit, die mehr Rechenleistung benötigt, als das aktuell für diese Fahrzeugfunktion vorgesehene Steuergerät, also dessen Hardware, bereitzustellen in der Lage ist, so ist auch eine Neukonstruktion des Steuergeräts notwendig, was die Entwicklung einer solchen Fahrzeugfunktion aufwendig macht. Das Steuergerät kann nicht einfach erweitert werden, damit neue oder zusätzliche Funktionalitäten implementiert werden können, die mehr Rechenleistung erfordern.

Aus der DE 10 2004 022 614 B3 ist ein Steuergerät für ein Kraftfahrzeug bekannt, das sich in Bezug auf seine technische Ausstattung erweitern lässt, indem in das Gehäuse des Steuergeräts zusätzliche Schaltungen eingesteckt werden, die auch eine zusätzliche Anschlussmöglichkeit für zusätzliche Sensoren und Aktuatoren aufweisen. Die Schaltungen sind also immer dann nötig, wenn man einen speziellen Sensor oder Aktuator anschließen möchte. Eine flexible Nutzung einer solchen zusätzlichen Schaltung ist somit nicht möglich, da jede Schaltung ein spezifisches Sensor/Aktuator-Interface mit sich bringt.

Aus der DE 10 2008 000 817 A1 ist ein skalierbares Fahrerassistenzsystem für ein Kraftfahrzeug bekannt, wobei sich die Skalierbarkeit auf die Anzahl der anschließbaren Kameras sowie die Anzahl der miteinander verschalteten Steuergeräte bezieht. Ist mehr Rechenleistung nötig, müssen entsprechend viele Steuergeräte zusammengeschaltet werden. Dies vergrößert aber den Vernetzungsaufwand.

Aus der DE 10 2012 009 482 A1 ist ein funktional erweiterbares Steuergerät bekannt, in welches sich optional mehrere Anwendungsmodule einstecken lassen, die Funktionalitäten des Steuergeräts bereitstellen. Da alle Anwendungsmodule in ein und demselben Gehäuse angeordnet sind, ist eine Klimatisierung des Steuergeräts auf die maximal mögliche Anzahl an Anwendungsmodulen auszulegen. Dies kann in vielen Fällen aber eine Überdimensionierung bedeuten.

Aus der DE 101 59 480 A1 geht hervor, dass in einem Steuergerät zusätzliche Zellen angeschlossen werden können, bei denen es sich um FPGA-Bausteine handeln kann, die je nach Bedarf im Steuergerät an unterschiedliche Berechnungsaufgaben angepasst werden können.

Aus der DE 10 2014 219 469 A1 ist bekannt, dass in ein Steuergerät durch eine Öffnung des Gehäuses hindurch ein Zusatzmodul eingesteckt werden kann, um einen weiteren Mikrocontroller im Steuergerät bereitstellen zu können. Der bereits im Steuergerät vorhandenen Mik2rocontroller und der zusätzliche Mikrocontroller kommunizieren dabei über DMA, Direct Memory Access.

Aus dem DE 10 2005 010 476 A1 ist bekannt, dass auf der Chipfläche eines Steuergeräts frei konfigurierbare Module auf Teil-Chipflächen bereitgestellt werden können, die als FPGA betrieben und damit adaptiert werden können.

Der Erfindung liegt die Aufgabe zugrunde, ein Steuergerät für ein Kraftfahrzeug flexibel an den Bedarf an Rechenleistung einer Fahrzeugfunktion anpassen zu können, die mittels des Steuergeräts in dem Kraftfahrzeug implementiert oder bereitgestellt werden soll.

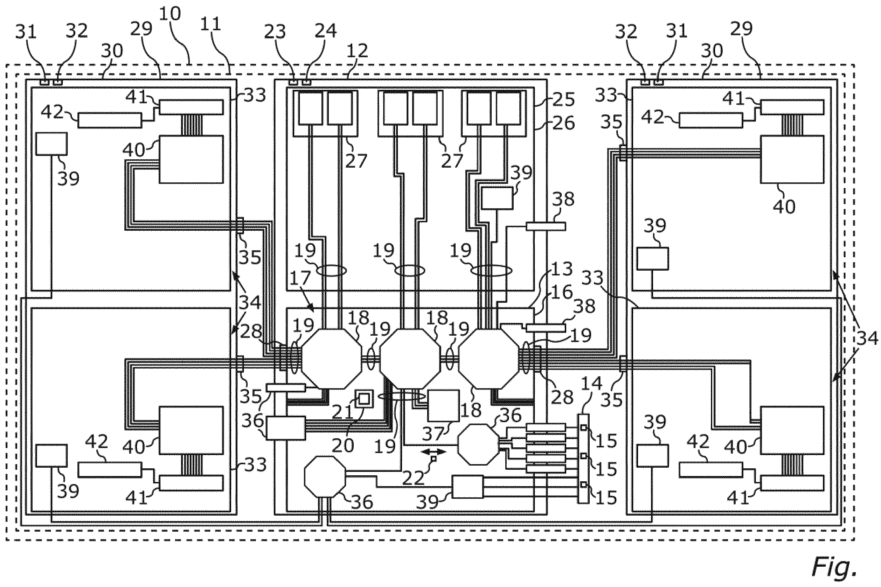

Die Aufgabe wird durch die Gegenstände der unabhängigen Patentansprüche gelöst. Vorteilhafte Ausführungsformen der Erfindung sind durch die abhängigen Patentansprüche, die folgende Beschreibung sowie die Figur beschrieben.

Durch die Erfindung ist ein elektronisches Steuergerät (ECU - Electronic Control Unit) für ein Kraftfahrzeug bereitgestellt. Das Steuergerät weist ein Gehäuse auf, das hier als zentrales Modulgehäuse bezeichnet ist. In dem zentralen Modulgehäuse ist eine Kommunikationseinheit angeordnet, die dazu eingerichtet ist, Kommunikationsdaten mit zumindest einer geräteexternen Fahrzeugkomponente mittels eines vorbestimmten Kommunikationsprotokolls auszutauschen. Mit "geräteextern" ist gemeint, dass die jeweilige Fahrzeugkomponente nicht Teil des Steuergeräts ist, sondern beispielsweise ein anderes Steuergerät oder eine Sensoreinheit oder eine Aktuatoreinheit darstellt. Als Kommunikationsprotokoll kann beispielsweise ein Busprotokoll, wie beispielsweise für den CAN-Bus (CAN - Controller Area Network), oder ein Netzwerkprotokoll, wie beispielsweise für das Ethernet-Protokoll, oder das IP (Internet Protokoll) vorgesehen sein. Über eine Kommunikationseinheit der genannten Art kann also beispielsweise ein Prozessorsystem des Steuergeräts Kommunikationsdaten, beispielsweise Zustandsdaten der zumindest einen Fahrzeugkomponente und/oder Steuerbefehle für die zumindest eine Fahrzeugkomponente, mit dieser austauschen, also von dieser empfangen und/oder an diese aussenden.

Bei dem erfindungsgemäßen Steuergerät ist für die Weiterleitung oder Verteilung der Kommunikationsdaten innerhalb des Steuergeräts durch die besagte Kommunikationseinheit ein geräteinternes Bussystem bereitgestellt. Mit "geräteintern" ist hierbei gemeint, dass sich Busleitungen des Bussystems nur innerhalb des Steuergeräts erstrecken und nicht aus dem Steuergerät heraus bis beispielsweise zu der zumindest einen Fahrzeugkomponente verlegt sind.

Für eine Kommunikation mittels eines Kommunikationsprotokolls sind Adressen notwendig, um einen Absender und/oder einen Empfänger einer Kommunikationsnachricht oder eines Datenpakets zu identifizieren. Eine Controllereinrichtung des Bussystems ist hierbei dazu eingerichtet, die besagten Kommunikationsdaten innerhalb des Steuergeräts mittels eines Busprotokolls weiterzuleiten, das von dem zumindest einen Kommunikationsprotokoll dahingehend verschieden ist, dass der Adressraum des Busprotokolls unabhängig von dem Adressraum des zumindest einem geräteexternen Kommunikationsprotokolls ist. Innerhalb des Steuergeräts werden die Kommunikationsdaten bei dem erfindungsgemäßen Steuergerät also über das Bussystem übertragen, in welchem Busadressen verwendet werden, die verschieden oder zumindest unabhängig sind von denjenigen Kommunikationsadressen, die außerhalb des Steuergeräts bei der Übertragung der Kommunikationsdaten zwischen dem Steuergerät einerseits und der zumindest einen Fahrzeugkomponente andererseits verwendet werden. Grund dafür ist, dass innerhalb des Steuergeräts die Kommunikationsdaten mittels des geräteinternen Bussystems übertragen oder weitergeleitet werden, das nicht für die geräteexterne Übertragung der Kommunikationsdaten verwendet wird.

Das Bussystem wird dazu genutzt, das Steuergerät in Bezug auf seine Performanz oder Rechenleistung skalierbar zu machen. Hierzu ist vorgesehen, dass das Bussystem zumindest einen Busanschluss für zumindest eine jeweilige, von der Kommunikationseinheit verschiedene zusätzliche Rechenmoduleinheit des Steuergeräts aufweist und hierbei der zumindest eine Busanschluss dazu eingerichtet ist, die jeweilige Rechenmoduleinheit von außen an das zentrale Modulgehäuse anzuschließen. Mit anderen Worten lassen sich an das Bussystem Busteilnehmer anschließen, die dann die Kommunikationsdaten senden oder empfangen können. Als Busteilnehmer kann jeweils beispielsweise eine Rechenmoduleinheit oder ein in der Rechenmoduleinheit bereitgestelltes Prozessorsystem vorgesehen sein, das jeweils an einen Busanschluss angeschlossen werden kann. Dieser jeweilige Busanschluss ist dabei dazu eingerichtet, das Prozessorsystem der jeweiligen Rechenmoduleinheit von außen an das zentrale Modulgehäuse anzukoppeln. Mit anderen Worten kann an das fertig konstruierte zentrale Modulgehäuse von außen zumindest eine zusätzliche Rechenmoduleinheit mit zumindest einem darin enthaltenen zusätzlichen Prozessorsystem angeschlossen werden. Hierdurch lässt sich dann die Rechenleistung der zumindest einen zusätzlichen Rechenmoduleinheit in dem Steuergerät nutzen. Die zu verarbeitenden Kommunikationsdaten und/oder die bei der Verarbeitung erzeugten Kommunikationsdaten werden dabei mittels der Kommunikationseinheit des zentralen Modulgehäuses verteilt, d.h. zwischen der zumindest einen Rechenmoduleinheit einerseits und der zumindest einen fahrzeugexternen Fahrzeugkomponente andererseits übertragen oder ausgetauscht. Ein einzelnes Prozessorsystem kann beispielsweise auf der Grundlage einer Schaltungsplatine und/oder eines SoC (System on Chip) realisiert sein.

Durch die Erfindung ergibt sich der Vorteil, dass ein modular erweiterbares Steuergerät bereitgestellt ist, bei welchem über zumindest einen Busanschluss, bevorzugt mehrere Busanschlüsse, jeweils eine zusätzliche Rechenmoduleinheit angeschlossen oder angefügt werden kann, durch welche dann in dem Steuergerät zusätzliche Rechenleistung bereitgestellt werden kann. Das einmal fertig konstruierte zentral Modulgehäuse mit der Kommunikationseinheit muss hierbei nicht mehr umkonstruiert (redesigned) werden.

Bei der Erfindung ist die Controllereinrichtung dazu eingerichtet, eine Adresszuordnung (auch als Adressmapping bezeichnet) zwischen einer jeweiligen Kommunikationsadresse, die gemäß dem zumindest einen Kommunikationsprotokoll (für den geräteexternen Datenaustausch) vorgegeben ist, einerseits und einer jeweiligen Busadresse des Adressraums des Bussystems andererseits durchzuführen. Mit anderen Worten kann eine Kommunikationsadresse für das zumindest eine geräteexterne Kommunikationsprotokoll auf eine jeweilige korrespondierende Busadresse des Bussystems abgebildet werden. Somit werden also die Kommunikationsadressen für die geräteexterne Kommunikation (Austausch der Kommunikationsdaten) auf das Adressschema des Bussystems abgebildet. Dies geschieht durch die Controllereinheit, sodass also für die Busteilnehmer des Bussystems und/oder für die zumindest eine geräteexterne Fahrzeugkomponente das Bussystem bei der Kommunikation transparent bleibt. Es ist somit keine Anpassung der zumindest einen geräteexternen Fahrzeugkomponente notwendig, wenn in einem Kraftfahrzeug eine Ausführungsform des Steuergeräts eingebaut werden soll.

In der Erfindung ist vorgesehen, dass die zumindest eine Rechenmoduleinheit jeweils ein eigenes Modulgehäuse aufweist. Das zentrale Modulgehäuse und das jeweilige Modulgehäuse der zumindest einen zusätzlichen Rechenmoduleinheit weisen dabei jeweils ein eigenes Netzteil (d.h. eine eigene Stromversorgung und/oder Spannungsstabilisierung) und/oder eine eigene Kühleinrichtung auf. Mit anderen Worten lässt sich also jedes Modulgehäuse in Bezug auf Energieversorgung und/oder Kühlung unabhängig von den jedem anderen Modulgehäuse betreiben. Wird also an das zentrale Modulgehäuse, in welchem sich die Kommunikationseinheit befindet, eine zusätzliche Rechenmoduleinheit angeschlossen, so ergibt sich hierdurch keine zusätzliche Belastung des Netzteils und/oder der Kühleinrichtung des zentralen Modulgehäuses. Stattdessen bringt jede Rechenmoduleinheit ihr eigenes Netzteil und/oder ihre eigene Kühleinrichtung mit. Somit ist beim Erweitern des Steuergeräts um ein eine weitere Rechenmoduleinheit keinerlei Redesign der Hardware des zentralen Modulgehäuses notwendig. Es ist dann lediglich notwendig, beispielsweise durch vorgeben einer neuen Routingtabelle, die neu hinzugefügte Rechenmoduleinheit in die Datenkommunikation betreffend die Kommunikationsdaten einzubinden oder zu integrieren, sodass diejenigen Kommunikationsdaten, die für die neue Rechenmoduleinheit vorgesehen sind, zu dieser hin über das Bussystem übertragen werden.

Alternativ dazu oder zusätzlich ist in der Erfindung ist vorgesehen, dass die zumindest eine Rechenmoduleinheit jeweils Einbauplätze für mehrere Prozessorsysteme aufweist und jeder Einbauplatz der Rechenmoduleinheit dazu eingerichtet ist, das Prozessorsystem dieses Einbauplatzes individuell, d.h. unabhängig von jedem anderen Prozessorsystem der Rechenmoduleinheit mit dem Bussystem zu verbinden. Mit anderen Worten kann also über den Busanschluss des Bussystems, an welchem eine Rechenmoduleinheit angeschlossen ist, mehr als ein Prozessorsystem in das Steuergerät eingebunden oder in das Steuergerät integriert werden. Hierbei ist aber jedes Prozessorsystem eigenständig angeschlossen. Hierdurch ergibt sich der Vorteil, dass in der Rechenmoduleinheit jedes Prozessorsystem unabhängig davon betrieben werden kann, ob alle Einbauplätze belegt sind. Somit kann also innerhalb der Rechenmoduleinheit die Rechenleistung ebenfalls skaliert werden, in dem festgelegt wird, wie viele Prozessorsysteme in der Rechenmoduleinheit eingebaut oder bereitgestellt werden. Jeder Einbauplatz bietet eine unabhängige Anschlussmöglichkeit eines Prozessorsystems an das Bussystem, also z.B. eine Verbindung zwischen der Schaltungsplatine des Prozessorsystems und dem Busanschluss am zentralen Modulgehäuse.

Alternativ dazu oder zusätzlich ist in der Erfindung vorgesehen, dass die zumindest eine Rechenmoduleinheit konsequent als geräteinterne Erweiterung gedacht ist, indem bei dem Steuergerät die zumindest eine Rechenmoduleinheit eine Datenverbindung zur geräteexternen Peripherie, also insbesondere zu der zumindest einen Fahrzeugkomponente, ausschließlich über die Kommunikationseinheit im zentralen Modulgehäuse vorgesehen ist. Die zumindest eine Rechenmoduleinheit weist also zu der geräteexternen Peripherie keine eigene Kommunikationsverbindung auf, welche das zentrale Modulgehäuse, insbesondere dessen Kommunikationseinheit, umgehen würde.

Zu der Erfindung gehören auch Ausführungsformen, durch die sich zusätzliche Vorteile ergeben.

In einer Ausführungsform ist die Controllereinheit des Bussystems dazu eingerichtet, die Kommunikationsdaten gemäß einer vorgegebenen Routingtabelle in dem Bussystem zu routen oder zu übertragen. In anderen Worten ist durch die Routingtabelle festgelegt, zu welchem Busteilnehmer, also beispielsweise zu welcher Rechenmoduleinheit eintreffende Kommunikationsdaten übertragen werden müssen und/oder zu welcher Fahrzeugkomponente die Kommunikationsdaten einer spezifischen Rechenmoduleinheit übertragen werden müssen. Diese Routingtabelle ist vorgebbar, sodass das Routing oder die Übertragung in dem Bussystem konfigurierbar ist. Die Routingtabelle kann beispielsweise als eine Datei oder als ein Datensatz in dem Steuergerät gespeichert sein. Wird das Steuergerät in Bezug auf die Anzahl der angeschlossenen Rechenmoduleinheit verändert, so kann durch Anpassen der Routingtabelle dies berücksichtigt werden.

In einer Ausführungsform ist die Controllereinrichtung des Bussystems dazu eingerichtet, eine Adressvergabe einer jeweiligen Busadresse für einen jeweiligen geräteinternen, bei dem Start am Bussystem angeschlossenen Busteilnehmer dynamisch bei dem jeweiligen Start des Steuergeräts durchzuführen. Mit anderen Worten wird der Adressraum automatisiert durch die Controllereinrichtung verwaltet oder eingerichtet. Somit kann das Steuergerät umgerüstet werden und es erfolgt dennoch eine eindeutige Vergabe von Busadressen an Busteilnehmer.

Wie bereits ausgeführt, ist das Bussystem unabhängig von der Kommunikationstechnologie, die geräteextern vorgesehen und an welche das Steuergerät angeschlossen werden kann. Mit anderen Worten ist also insbesondere vorgesehen, dass das geräteinterne Bussystem auf einem von dem zumindest eine geräteexternen Kommunikationsprotokoll verschiedenes Busprotokoll basiert. Als besonders vorteilhaft hat sich hierbei herausgestellt, wenn das Bussystem auf der Grundlage einer PCle-Technologie (PCle - Peripheral Component Interconnect Express) bereitgestellt ist. Diese bietet die Bandbreite für die Übertragung von Kommunikationsdaten, wie sie bei einem Steuergerät insbesondere für Kommunikationsdaten zur Bereitstellung einer autonomen Fahrfunktion benötigt wird.

In einer Ausführungsform weist die zumindest eine Rechenmoduleinheit ein einziges Prozessorsystem auf, dass durch die anschließende Rechenmoduleinheit dem Steuergerät zugefügt wird.

In einer Ausführungsform ist bereits in dem zentralen Modulgehäuse zumindest ein Basis-Prozessorsystem angeordnet, welches dazu eingerichtet ist, unabhängig von einer zusätzlichen Rechenmoduleinheit, also ohne dass eine zusätzliche Rechenmoduleinheit an einem Busanschluss angeschlossen ist, eine Fahrzeugfunktion bereitzustellen, also die besagten Kommunikationsdaten zu erzeugen (für ausgesendete Kommunikationsdaten) und/oder zu verarbeiten (für empfangene Kommunikationsdaten). Mit anderen Worten kann das Steuergerät auch ausschließlich auf der Grundlage des zentralen Modulgehäuses in Betrieb genommen werden. In dem zentrale Modulgehäuse ist hierzu eine Basis-Rechenleistung auf der Grundlage des zumindest einen Basis-Prozessorsystems bereitgestellt. Ist das Steuergerät beispielsweise für eine autonome Fahrfunktion vorgesehen, so kann in dem zentralen Modulgehäuse beispielsweise die in jedem Fall notwendige Bildverarbeitung, d.h. ein "computer vision processing", realisiert sein. Sollen dann zusätzliche Funktionalitäten der autonomen Fahrfunktion, beispielsweise eine Objektklassifikation von erkannten Objekten, bereitgestellt werden, so kann die hierzu benötigte Rechenleistung mittels zumindest einer zusätzlichen Rechenmoduleinheit in dem Steuergerät hinzugefügt oder angeschlossen werden.

In einer Ausführungsform ist die Controllereinrichtung des Bussystems dazu eingerichtet, als das zumindest eine Kommunikationsprotokoll zumindest eines der folgenden zu betreiben oder zu verwenden: Ethernet, zumindest ein Datenbusprotokoll, insbesondere CAN und/oder LIN (Local Interconnect Network), eine Sensorkommunikation mit zumindest einer Sensoreinheit, insbesondere einer Kamera und/oder einen Radar. Somit lassen sich in dem Steuergerät gängige Kommunikationsverbindungen zu einer geräteexternen Peripherie mittels der Controllereinrichtung unterstützen oder betreiben.

Es ist keine aufwändige Anpassung der Software für die zumindest eine Rechenmoduleinheit notwendig, da die eigentliche Kommunikation bereits durch die Controllereinrichtung unterstützt werden kann.

In einer Ausführungsform ist mehr als ein Busanschluss für eine jeweilige Rechenmoduleinheit vorgesehen. Beispielsweise können zwei Busanschlüsse vorgesehen sein. In einer Ausführungsform ist hierbei vorgesehen, dass die Controllereinheit dazu eingerichtet ist, über das Bussystem auch eine geräteinterne Datenübertragung und/oder einen geräteinterne DMA-Transfer (DMA - Direct Memory Access) zwischen den unterschiedlichen Busanschluss durchzuführen, also zwischen unterschiedlichen Rechenmoduleinheiten. Mit anderen Worten ist die Controllereinheit dazu eingerichtet, auch die Prozessorsysteme untereinander für einen Datenaustausch oder eine Datenübertragung zu verbinden. Beim DMA-Transfer wird hierbei der Speicherinhalt eines Datenspeichers, insbesondere eines RAM (Random Access Memory), aus einem Prozessorsystem in einen Datenspeicher, insbesondere einen RAM, eines anderen Prozessorsystems durch die Controllereinrichtung kopiert, nachdem eines der Prozessorsysteme diese Datenübertragung angestoßen oder ausgelöst hat. Hierdurch ist z.B. eine Interprozess-Kommunikation über das Bussystem hinweg möglich. Dies beschleunigt die Koordination und/oder die Zusammenarbeit zwischen Programmprozessen, die auf unterschiedlichen Prozessorsystemen ablaufen oder ausgeführt werden.

In einer Ausführungsform weist das Steuergerät eine Betriebssoftware für eine autonome Fahrfunktion des Kraftfahrzeugs auf. Das Steuergerät ist hierbei dazu eingerichtet, im Betrieb mittels der Betriebssoftware die autonome Fahrfunktion bereitzustellen. Mit anderen Worten handelt es sich bei dem Steuergerät um einen Teil eines Autopiloten. Beispielsweise kann durch das Steuergerät die Umgebungserkennung auf Grundlage von beispielsweise zumindest einer Kamera und/oder zumindest einem Radar und/oder zumindest einem Lidar, implementiert sein.

Die Erfindung umfasst auch das Kraftfahrzeug, welches eine Ausführungsform des erfindungsgemäßen Steuergeräts aufweist. Das erfindungsgemäße Kraftfahrzeug kann beispielsweise ein Kraftwagen sein, also beispielsweise ein Personenkraftwagen oder ein Lastkraftwagen. Das Kraftfahrzeug kann auch ein Motorrad sein.

Um das erfindungsgemäße Steuergerät modular erweitern zu können, ist die beschriebene Rechenmoduleinheit für das Steuergerät notwendig. Die Erfindung umfasst entsprechend auch eine solche Rechenmoduleinheit mit einem Modulgehäuse, welches eine Anschlusseinrichtung zum Anschließen der Rechenmoduleinheit an einen Busanschluss eines Bussystems eines zentralen Modulgehäuses des Steuergeräts aufweist. Zudem ist zumindest ein Prozessorsystem in dem Modulgehäuse der Rechenmoduleinheit bereitgestellt. Mittels der Rechenmoduleinheit kann also das Steuergerät um das zumindest eine Prozessorsystem erweitert werden, indem die Anschlusseinrichtung der Rechenmoduleinheit mit einem Busanschluss des Bussystems des zentralen Modulgehäuses verbunden wird. Die Anschlusseinrichtung kann beispielsweise eine Steckverbindung vorsehen, um das Modulgehäuse der Rechenmoduleinheit an das zentrale Modulgehäuse anstecken zu können. Zusätzlich oder alternativ dazu kann eine mechanische Verbindung beispielsweise mittels einer Schraubverbindung und/oder einer Rastverbindung vorgesehen sein.

Die Erfindung umfasst auch Ausführungsformen der Rechenmoduleinheit mit denjenigen zusätzlichen Merkmalen, wie sie bereits im Zusammenhang mit den Ausführungsformen des erfindungsgemäßen Steuergeräts beschrieben worden sind. Aus diesem Grund werden diese zusätzlichen Merkmale hier nicht noch einmal beschrieben.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar.

Die Erfindung wird nun anhand eines bevorzugten Ausführungsbeispiels sowie unter Bezugnahme auf die Zeichnung näher erläutert. Es zeigt die einzige Figur (Fig.) eine schematische Darstellung einer Ausführungsform des erfindungsgemäßen Kraftfahrzeugs.

In der Figur bezeichnen identische Bezugszeichen jeweils funktionsgleiche Elemente.

Die Figur zeigt ein Kraftfahrzeug 10. Das Kraftfahrzeug 10 kann als Kraftwagen, beispielsweise Personenkraftwagen oder Lastkraftwagen, oder als Motorrad ausgestaltet sein. In dem Kraftfahrzeug 10 kann ein Steuergerät 11 vorgesehen sein. Das Steuergerät 11 kann eine Fahrzeugfunktion in dem Kraftfahrzeug 10 bereitstellen, beispielsweise eine Fahrfunktion für ein autonomes Fahren (autonome Fahrfunktion).

Um bei einer Weiterentwicklung der Fahrzeugfunktion die Hardware des Steuergeräts 11 flexibel anpassen zu können, also einen steigenden Bedarf an Rechenleistung bei Erweiterung der Fahrzeugfunktion decken zu können, kann das Steuergerät 11 modular ausgestaltet sein.

Das Steuergerät 11 kann hierzu ein zentrales Modulgehäuse 12 aufweisen, in welchem eine Kommunikationseinheit 13 bereitgestellt sein kann, durch welche ein Datenaustausch von Kommunikationsdaten 22 mit der geräteexternen Peripherie 14 und zusätzlich auch ein geräteinterner Datenaustausch durchgeführt werden kann. Die geräteexterne Peripherie 14 kann zumindest eine Fahrzeugkomponente 15 des Kraftfahrzeugs 10 umfassen, beispielsweise zumindest ein anderes Steuergerät und/oder zumindest einen Sensor. Die Kommunikationseinheit 13 kann beispielsweise auf der Grundlage einer Schaltungsplatine 16 gebildet sein.

Die Kommunikationseinheit 13 kann für die geräteinterne Datenübertragung in dem Steuergerät 11 ein Bussystem 17 bereitstellen oder betreiben. Das Bussystem 17 kann beispielsweise zumindest eine Datenweiche oder einen Switch 18 aufweisen. In der Figur sind beispielhaft drei Switches A, B, C dargestellt. Bei dem Bussystem kann es sich beispielsweise um ein PCle-Bussystem handeln. Zur Veranschaulichung von Kommunikationswegen sind in der Figur Datenleitungen 19 des Bussystems 17 dargestellt. Der Übersichtlichkeit halber sind nicht alle Datenleitungen mit einem Bezugssystem versehen.

Eine Controllereinrichtung 20 des Bussystems 17 kann dazu eingerichtet sein, bei einem Start des Steuergeräts 11 den dann am Bussystem 17 angeschlossenen Busteilnehmern dynamisch eine Busadresse zuzuweisen, um jedem Busteilnehmer eindeutig adressieren zu können. Es kann zusätzlich vorgesehen sein, dass mittels einer Routingtabelle 21 der Controllereinrichtung 20 vorgegeben wird, wie Kommunikationsdaten 22 in dem Bussystem 17 zu routen oder zuzuordnen sind. Die Controllereinrichtung 20 kann als zumindest ein integrierter Schaltkreis bereitgestellt sein.

In dem zentralen Modulgehäuse 12 kann für den Betrieb der Kommunikationseinheit 13 ein Netzteil 23 für eine Stromversorgung und/oder eine Kühleinrichtung 24 für eine Abfuhr von Abwärme bereitgestellt sein. Somit lässt sich das Modulgehäuse 12 an eine elektrische Energieversorgung des Kraftfahrzeugs 10, beispielsweise ein elektrisches Bordnetz, anschließen und dann die Kommunikationseinheit 13 in dem zentralen Modulgehäuse 12 betreiben.

In dem zentralen Modulgehäuse 12 kann zusätzlich zur Kommunikationseinheit 13 zumindest ein Basis-Prozessorsystem 25 bereitgestellt sein, dass beispielsweise auf einer eigenen Schaltungsplatine 26 beruhen kann. Durch das zumindest eine Basis-Prozessorsystem 25 kann eine Basis-Funktionalität des Steuergeräts 11 implementiert oder realisiert sein. Hierzu kann beispielsweise zumindest eine Recheneinheit 27 vorgesehen sein, durch welche eine Betriebssoftware oder ein Teil einer Betriebssoftware des Steuergeräts 11 ausgeführt werden kann. Beispielsweise kann durch das Basis-Prozessorsystem 25 eine Bildverarbeitung, d.h. ein computer vision processing, implementiert oder durchgeführt werden.

Um nun eine Rechenleistung über das zumindest eine Basis-Prozessorsystem 25 hinaus erweitern zu können, kann das Bussystem 17 zumindest einen Busanschluss 28 aufweisen, an welchen jeweils eine zusätzliche Rechenmoduleinheit 29 angeschlossen werden kann. Jede Rechenmoduleinheit 29 kann ein eigenes Modulgehäuse 30 aufweisen, in welchem jeweils ein eigenes Netzteil 31 und/oder eine eigene Kühleinrichtung 32 bereitgestellt sein kann. In jeder Rechenmoduleinheit 29 kann jeweils ein oder mehr als ein eigenes Prozessorsystem 33 bereitgestellt sein, d. h. es kann sich in jedem Modulgehäuse 30 zumindest ein Einbauplatz 34 für ein jeweiliges Prozessorsystem 33 befinden. Hierbei kann in jeder Rechenmoduleinheit 29 eine Anschlusseinrichtung 35 vorgesehen sein, über welche das jeweilige Prozessorsystem 33 der Rechenmoduleinheit 29 individuell, d. h. unabhängig von jedem übrigen Prozessorsystem 33 derselben Rechenmoduleinheit 29, mit dem Busanschluss 28 des Bussystems 17 im zentralen Modulgehäuse 12 verbunden werden kann. Somit kann auch eine Rechenmoduleinheit 29 mit mehreren Einbauplätzen 34 angeschlossen werden, bei welcher aber nicht alle Einbauplätze 34 mit einem jeweiligen Prozessorsystem 33 belegt oder ausgestattet sein müssen.

Durch das jeweilige eigene Netzteil 31 und/oder die jeweilige eigene Kühleinrichtung 32 in jeder Rechenmoduleinheit 29 stellt das Anschließen einer Rechenmoduleinheit 29 an das zentrale Modulgehäuse 12 keine zusätzliche Belastung für das Netzteil 23 und/oder die Kühleinrichtung 24 dar.

Die dargestellten zwei Busanschlüsse 28 sind nur beispielhaft. Es kann ein einzelner Busanschluss 28 oder es können mehr als zwei Busanschlüsse 28 in dem Steuergerät 11 vorgesehen sein.

Durch die Controllereinrichtung 20 können dabei Kommunikationsdaten 22 zwischen den Prozessorsystemen 25, 33 untereinander und zwischen den Basis-Prozessorsystemen 25, 33 einerseits und Anschlusscontrollern 36 für die Peripherie 14, also für die zumindest eine Fahrzeugkomponente 15 oder zu diesen führenden externen Bussystemen, andererseits übertragen werden. Dies geschieht insbesondere durch ein Tunneln, d. h. das Umsetzen oder Übersetzen von Kommunikationsadressen für die geräteexterne Kommunikation einerseits und Busadressen des Bussystems 17 andererseits kann durch die Controllereinrichtung 20 selbständig durchgeführt werden.

Es können Anschlusscontroller 36 zum Anschließen eines Busnetzwerks (zum Beispiel CAN und/oder LIN) und/oder zumindest eines Radarsensors und/oder zumindest einer Kamera und/oder zumindest eines Lidar und/oder zumindest einer Mikrofonanordnung und/oder zumindest eines Fallback-Steuergeräts vorgesehen sein. Über das Bussystem 17 kann auch eine Loggingeinrichtung 37 mit Logging-Daten versorgt werden.

Es kann ein direkter Ausleseanschluss 38 zum Auslesen von Debugging-Daten aus dem Bussystem 17 vorgesehen sein.

Für jedes Prozessorsystem 25, 33 kann jeweils eine Überwachungsschaltung 39 vorgesehen sein, die beispielsweise eine sogenannte Heartbeat-Funktionalität bereitstellen kann. Kommt es zu einem Defekt in einem Prozessorsystem 25, 33, so kann die Überwachungsschaltung 39 dieses Prozessorsystems 25, 33 dies signalisieren. Daraufhin kann dann beispielsweise durch die Controllereinrichtung 20 ein Routing der Kommunikationsdaten 22 und/oder der geräteinternen Datenübertragung angepasst werden, um die Softwarefunktion des defekten Prozessorsystems 25, 33 mittels zumindest eines anderen, noch funktionsfähigen Prozessorsystems 25, 33 zu ersetzen.

Die Figur zeigt zudem, wie für jedes Prozessorsystem 33 einer Rechenmoduleinheit 29 zusätzlich zur eigentlichen Mikroprozessoranordnung 40 über einen Kommunikationschip 41 eine Funktionsüberwachung 42 unabhängig von der eigentlichen Mikroprozessoranordnung 40 eine Funktionalität und/oder Plausibilität der Funktion des Prozessorsystem 33 überwachen kann. Hierdurch kann ein Sicherheitsniveau des Prozessorsystems 33 beispielsweise auf das Niveau ASIL-D angehoben werden.

Bei dem Steuergerät 11 wird also durch Aufsplitten oder Aufteilen der bereitgestellten Fahrzeugfunktion auf mehrere separate Rechenmoduleinheit und die Kopplung oder Verknüpfung der Rechenmoduleinheit mittels der Kommunikationseinheit insbesondere basierend auf PCle-Technologie eine modulare Erweiterbarkeit der Rechenleistung des Steuergeräts 11 ermöglicht. Durch Verwendung der PCle-Technologie wird eine ausreichende Bandbreite, Abstraktion und Erweiterbarkeit garantiert. Es können bevorzugt zwei bis fünf unabhängige Rechenmoduleinheiten 29 mit jeweils einem eigenen Modulgehäuse 30, eigener Stromversorgung durch eigenes Netzteil 31 und Kühlung durch eigene Kühleinrichtung 32 vorgesehen sein.

Die Rechenmoduleinrichtungen werden bevorzugt über PCIe an die Kommunikationseinheit des zentralen Modulgehäuses angeschlossen und sind damit Teil des Steuergeräts. Das Steuergerät wird so modular erweiterbar, da jede Erweiterung durch eine jeweilige Rechenmoduleinheit ihre eigene Stromversorgung und Kühlung mitbringen kann.

### Bezugszeichenliste

- 10: Kraftfahrzeug
- 11: Steuergerät
- 12: Modulgehäuse
- 13: Kommunikationseinheit
- 14: Peripherie
- 15: Fahrzeugkomponente
- 16: Schaltungsplatine
- 17: Bussystem
- 18: Switch
- 19: Datenleitungen
- 20: Controllereinrichtung
- 21: Routingtabelle
- 22: Kommunikationsdaten
- 23: Netzteil
- 24: Kühleinrichtung
- 25: Basis-Prozessorsystem
- 26: Schaltungsplatine
- 27: Recheneinheit
- 28: Busanschluss
- 29: Rechenmoduleinheit
- 30: Modulgehäuse
- 31: Netzteil
- 32: Kühleinrichtung
- 33: Prozessorsystem
- 34: Einbauplatz
- 35: Anschlusseinrichtung
- 36: Anschlusscontroller
- 37: Loggingeinrichtung
- 38: Ausleseanschluss
- 39: Überwachungsschaltung
- 40: Mikroprozessoranordnung
- 41: Kommunikationschip
- 42: Funktionsüberwachung

## Patentansprüche

1. Elektronisches Steuergerät (11) für ein Kraftfahrzeug (10), aufweisend
- ein zentrales Modulgehäuse (12) und
- eine in dem Modulgehäuse (12) angeordnete Kommunikationseinheit (13), die dazu eingerichtet ist, Kommunikationsdaten (22) mit zumindest einer geräteexternen Fahrzeugkomponente (15) mittels zumindest eines vorbestimmten Kommunikationsprotokolls auszutauschen, wobei
durch die Kommunikationseinheit (13) ein geräteinternes Bussystem (17) bereitgestellt ist, wobei eine Controllereinrichtung (20) des geräteinternen Bussystems (17) eine Weiterleitung der Kommunikationsdaten (22) innerhalb des Steuergeräts (11) mittels eines Busprotokolls, das einen von dem zumindest einem Kommunikationsprotokoll unabhängigem Adressraum aufweist, vorsieht und das geräteinterne Bussystem (17) zumindest einen Busanschluss (28) für eine jeweilige von der Kommunikationseinheit (13) verschiedene zusätzliche Rechenmoduleinheit (29) des Steuergeräts (11) aufweist,
wobei der zumindest eine Busanschluss (28) dazu eingerichtet ist, die jeweilige Rechenmoduleinheit (29) von außen an das zentrale Modulgehäuse (12) anzuschließen,
**dadurch gekennzeichnet, dass**
die Controllereinrichtung (20) dazu eingerichtet ist, eine Adresszuordnung zwischen einer jeweiligen Kommunikationsadresse, die gemäß dem zumindest einen Kommunikationsprotokoll vorgegeben ist, einerseits und einer jeweiligen Busadresse des Adressraums des Bussystems (17) andererseits durchzuführen, sodass für die zumindest eine geräteexterne Fahrzeugkomponente (15) das geräteinterne Bussystem (17) bei der Kommunikation transparent bleibt, wobei
- die zumindest eine Rechenmoduleinheit (29) jeweils ein eigenes Modulgehäuse (30) aufweist und das zentrale Modulgehäuse (12) und das jeweilige Modulgehäuse (30) der zumindest einen zusätzlichen Rechenmoduleinheit (29) jeweils ein eigenes elektrisches Netzteil (23, 31) und/oder eine eigene Kühleinrichtung (24, 32) aufweisen, und/oder
- die zumindest eine Rechenmoduleinheit (29) jeweils Einbauplätze (34) für mehrere Prozessorsysteme (33) aufweist und jeder Einbauplatz (34) der jeweiligen Rechenmoduleinheit (29) dazu eingerichtet ist, das Prozessorsystem (33) dieses Einbauplatzes (34) unabhängig von jedem übrigen Prozessorsystem (33) der Rechenmoduleinheit (29) mit dem Bussystem (17) zu verbinden, und/oder
- bei dem Steuergerät (11) für die zumindest eine Rechenmoduleinheit (29) eine Datenverbindung an eine geräteexterne Peripherie (14) ausschließlich über die Kommunikationseinheit (13) des zentralen Modulgehäuses (12) vorgesehen ist.

2. Steuergerät (11) nach Anspruch 1, wobei die Controllereinrichtung (20) dazu eingerichtet ist, die Kommunikationsdaten (22) in dem Bussystem (17) gemäß einer vorgegebenen Routingtabelle (21) zu routen.

3. Steuergerät (11) nach einem der vorhergehenden Ansprüche, wobei die Controllereinrichtung (20) dazu eingerichtet ist, eine Adressvergabe einer jeweiligen Busadresse aus dem Adressraum des Bussystems (17) an einen jeweiligen geräteinternen, bei einem jeweiligen Start des Steuergeräts (11) am Bussystem (17) angeschlossenen Busteilnehmer des Bussystems (17) dynamisch während des jeweiligen Starts durchzuführen.

4. Steuergerät (11) nach einem der vorhergehenden Ansprüche, wobei das Bussystem (17) auf einem von dem zumindest einen Kommunikationsprotokoll verschiedenen Busprotokoll basiert.

5. Steuergerät (11) nach einem der vorhergehenden Ansprüche, wobei das Bussystem (17) auf der Grundlage einer PCle-Technologie bereitgestellt ist.

6. Steuergerät (11) nach einem der vorhergehenden Ansprüche, wobei in dem zentralen Modulgehäuse (12) zumindest ein Basis-Prozessorsystem (25) bereitgestellt ist, welches dazu eingerichtet ist, ohne eine angeschlossene zusätzliche Rechenmoduleinheit (29) die Kommunikationsdaten (22) zu erzeugen und/oder zu verarbeiten.

7. Steuergerät (11) nach Anspruch 6 in dessen Rückbezug auf die zweite Alternative in Anspruch 1 , wobei für jedes Prozessorsystem (25, 33) jeweils eine Überwachungsschaltung (39) vorgesehen ist, die dazu eingerichtet ist, dass für den Fall, dass es zu einem Defekt in einem Prozessorsystem (25, 33) kommt, die Überwachungsschaltung (39) dieses Prozessorsystems (25, 33) dies signalisiert, und daraufhin dann durch die Controllereinrichtung (20) ein Routing der Kommunikationsdaten (22) und/oder der geräteinternen Datenübertragung angepasst wird, um die Softwarefunktion des defekten Prozessorsystems (25, 33) mittels zumindest eines anderen, noch funktionsfähigen Prozessorsystems (25, 33) zu ersetzen.

8. Steuergerät (11) nach einem der vorhergehenden Ansprüche, wobei die Controllereinrichtung (20) der Kommunikationseinheit (13) dazu eingerichtet ist, als das zumindest eine Kommunikationsprotokoll zumindest eines der folgenden zu betreiben: Ethernet, zumindest ein Datenbusprotokoll, insbesondere CAN und/oder LIN, eine Sensorkommunikation mit zumindest einer Sensoreinheit, insbesondere einer Kamera und/oder einem Radar und/oder einem Lidar.

9. Steuergerät (11) nach einem der vorhergehenden Ansprüche, wobei mehr als ein Busanschluss (28) für eine jeweilige Rechenmoduleinheit (29) vorgesehen ist und die Controllereinrichtung (20) dazu eingerichtet ist, über das Bussystem (17) geräteintern eine Datenübertragung und/oder einen geräteinternen DMA-Transfer zwischen den unterschiedlichen Busanschlüssen (28) durchzuführen.

10. Steuergerät (11) nach einem der vorhergehenden Ansprüche, wobei das Steuergerät (11) eine Betriebssoftware für eine autonome Fahrfunktion des Kraftfahrzeugs (10) aufweist und dazu eingerichtet ist, im Betrieb mittels der Betriebssoftware die autonome Fahrfunktion bereitzustellen.

11. Kraftfahrzeug (10) mit zumindest einem Steuergerät (11) nach einem der vorhergehenden Ansprüche.

## Claims

1. Electronic controller (11) for a motor vehicle (10), having
- a central module housing (12) and
- a communication unit (13) arranged in the module housing (12) and that is designed to exchange communication data (22) with at least one vehicle component (15) external to the controller by way of at least one predetermined communication protocol, wherein the communication unit (13) provides a bus system (17) internal to the controller, wherein a controller apparatus (20) of the bus system (17) internal to the controller makes provision to forward the communication data (22) within the controller (11) by way of a bus protocol that has an address space independent of the at least one communication protocol, and the bus system (17) internal to the controller has at least one bus connection (28) for a respective additional computing module unit (29), different from the communication unit (13), of the controller (11),
wherein the at least one bus connection (28) is designed to connect the respective computing module unit (29) externally to the central module housing (12),
**characterized in that**
the controller apparatus (20) is designed to perform address assignment between a respective communication address, which is predefined in accordance with the at least one communication protocol, on the one hand, and a respective bus address of the address space of the bus system (17), on the other hand, such that the bus system (17) internal to the controller remains transparent during the communication for the at least one vehicle component (15) external to the controller, wherein
- the at least one computing module unit (29) has a respective dedicated module housing (30) and the central module housing (12) and the respective module housing (30) of the at least one additional computing module unit (29) each have a dedicated electric power supply (23, 31) and/or a dedicated cooling apparatus (24, 32), and/or
- the at least one computing module unit (29) has respective installation spaces (34) for multiple processor systems (33) and each installation space (34) of the respective computing module unit (29) is designed to connect the processor system (33) of this installation space (34) to the bus system (17) independently of every other processor system (33) of the computing module unit (29), and/or
- in the case of the controller (11), a data connection to a peripheral (14) external to the controller is provided solely via the communication unit (13) of the central module housing (12) for the at least one computing module unit (29).

2. Controller (11) according to Claim 1, wherein the controller apparatus (20) is designed to route the communication data (22) in the bus system (17) in accordance with a predefined routing table (21).

3. Controller (11) according to either of the preceding claims, wherein the controller apparatus (20) is designed to perform dynamic address allocation of a respective bus address from the address space of the bus system (17) to a respective bus subscriber, internal to the controller and connected to the bus system (17) upon respective starting of the controller (11), of the bus system (17) during the respective starting.

4. Controller (11) according to one of the preceding claims, wherein the bus system (17) is based on a bus protocol different from the at least one communication protocol.

5. Controller (11) according to one of the preceding claims, wherein the bus system (17) is provided on the basis of a PCIe technology.

6. Controller (11) according to one of the preceding claims, wherein at least one basic processor system (25) is provided in the central module housing (12), which basic processor system is designed to generate and/or to process the communication data (22) without a connected additional computing module unit (29).

7. Controller (11) according to Claim 6 when referring back to the second alternative in Claim 1, wherein provision is made, for each processor system (25, 33), for a respective monitoring circuit (39) that is designed such that, if there is a defect in a processor system (25, 33), the monitoring circuit (39) of this processor system (25, 33) signals this, and routing of the communication data (22) and/or of the data transmission internal to the controller is adjusted in response by the controller apparatus (20) in order to replace the software function of the defective processor system (25, 33) with at least one other processor system (25, 33) that is still functional.

8. Controller (11) according to one of the preceding claims, wherein the controller apparatus (20) of the communication unit (13) is designed to operate at least one of the following as the at least one communication protocol: Ethernet, at least one data bus protocol, in particular CAN and/or LIN, sensor communication with at least one sensor unit, in particular a camera and/or a radar and/or a lidar.

9. Controller (11) according to one of the preceding claims, wherein more than one bus connection (28) is provided for a respective computing module unit (29) and the controller apparatus (20) is designed to perform data transmission internal to the controller and/or a DMA transfer internal to the controller between the different bus connections (28) via the bus system (17).

10. Controller (11) according to one of the preceding claims, wherein the controller (11) has operating software for an autonomous driving function of the motor vehicle (10) and is designed to provide the autonomous driving function during operation by way of the operating software.

11. Motor vehicle (10) having at least one controller (11) according to one of the preceding claims.

## Revendications

1. Appareil de commande (11) électronique pour un véhicule automobile (10), possédant
- un boîtier de module central (12) et
- une unité de communication (13) disposée dans le boîtier de module (12), qui est conçue pour échanger des données de communication (22) avec au moins un composant de véhicule (15) externe à l'appareil au moyen d'au moins un protocole de communication prédéfini,
un système de bus (17) interne à l'appareil étant mis à disposition par l'unité de communication (13), un dispositif contrôleur (20) du système de bus interne à l'appareil (17) prévoyant une retransmission des données de communication (22) à l'intérieur de l'appareil de commande (11) au moyen d'un protocole de bus qui possède un espace d'adressage indépendant de l'au moins un protocole de communication, et le système de bus (17) interne à l'appareil possédant au moins un port de bus (28) pour une unité de module de calcul (29) respective supplémentaire de l'appareil de commande (11), différente de l'unité de communication (13),
l'au moins un port de bus (28) étant conçu pour raccorder l'unité de module de calcul (29) respective depuis l'extérieur au boîtier de module central (12),
**caractérisé en ce que**
le dispositif contrôleur (20) est conçu pour effectuer une attribution d'adresse entre, d'une part, une adresse de communication respective qui est prédéfinie conformément à l'au moins un protocole de communication et, d'autre part, une adresse de bus respective de l'espace d'adressage du système de bus (17), de telle sorte que le système de bus (17) interne à l'appareil reste transparent lors de la communication pour l'au moins un composant de véhicule (15) externe à l'appareil,
- l'au moins une unité de module de calcul (29) possédant respectivement un boîtier de module (30) propre et le boîtier de module central (12) ainsi que le boîtier de module (30) respectif de l'au moins une unité de module de calcul supplémentaire (29) possédant respectivement un bloc d'alimentation électrique (23, 31) propre et/ou un dispositif de refroidissement (24, 32) propre, et/ou
- l'au moins une unité de module de calcul (29) possédant respectivement des emplacements de montage (34) pour plusieurs systèmes à processeur (33) et chaque emplacement de montage (34) de l'unité de module de calcul (29) respective étant conçu pour connecter le système à processeur (33) de cet emplacement de montage (34) au système de bus (17) indépendamment de chaque autre système à processeur (33) de l'unité de module de calcul (29), et/ou
- une liaison de données vers un périphérique (14) externe à l'appareil exclusivement par le biais de l'unité de communication (13) du boîtier de module central (12) étant prévue au niveau de l'appareil de commande (11) pour l'au moins une unité de module de calcul (29).

2. Appareil de commande (11) selon la revendication 1, le dispositif contrôleur (20) étant conçu pour acheminer les données de communication (22) dans le système de bus (17) conformément à une table de routage (21) prédéfinie.

3. Appareil de commande (11) selon l'une des revendications précédentes, le dispositif contrôleur (20) étant conçu pour effectuer de manière dynamique, pendant le démarrage respectif, une attribution d'adresse d'une adresse de bus respective issue de l'espace d'adressage du système de bus (17) à un périphérique de bus respectif du système de bus (17), respectivement interne à l'appareil, connecté au système de bus (17) lors d'un démarrage respectif de l'appareil de commande (11).

4. Appareil de commande (11) selon l'une des revendications précédentes, le système de bus (17) étant basé sur un protocole de bus différent de l'au moins un protocole de communication.

5. Appareil de commande (11) selon l'une des revendications précédentes, le système de bus (17) étant fourni sur la base d'une technologie PCIe.

6. Appareil de commande (11) selon l'une des revendications précédentes, au moins un système à processeur de base (25) étant fourni dans le boîtier de module central (12), lequel est conçu pour générer et/ou pour traiter les données de communication (22) sans unité de module de calcul (29) supplémentaire raccordée.

7. Appareil de commande (11) selon la revendication 6 dans sa référence à la deuxième alternative de la revendication 1, un circuit de surveillance (39) étant respectivement prévu pour chaque système à processeur (25, 33), lequel est conçu de telle sorte que, dans le cas où un défaut se produit dans un système à processeur (25, 33), le circuit de surveillance (39) de ce système à processeur (25, 33) le signale et ensuite un acheminement des données de communication (22) et/ou la transmission des données internes à l'appareil est alors adapté par le dispositif contrôleur (20) afin de remplacer la fonction logicielle du système à processeur (25, 33) défectueux au moyen d'au moins un autre système à processeur (25, 33) encore apte à fonctionner.

8. Appareil de commande (11) selon l'une des revendications précédentes, le dispositif contrôleur (20) de l'unité de communication (13) étant conçu pour exploiter, en tant qu'au moins un protocole de communication, au moins l'un des suivants : Ethernet, au moins un protocole de bus de données, notamment CAN et/ou LIN, une communication par capteur avec au moins une unité de capteur, en particulier une caméra et/ou un radar et/ou un lidar.

9. Appareil de commande (11) selon l'une des revendications précédentes, plus d'un port de bus (28) étant prévues pour une unité de module de calcul (29) respective et le dispositif contrôleur (20) étant conçu pour effectuer, par le biais du système de bus (17) une transmission de données interne à l'appareil et/ou un transfert DMA interne à l'appareil entre les différents ports de bus (28).

10. Appareil de commande (11) selon l'une des revendications précédentes, l'appareil de commande (11) possédant un logiciel d'exploitation pour une fonction de conduite autonome du véhicule automobile (10) et étant conçu pour fournir, en fonctionnement, la fonction de conduite autonome au moyen du logiciel d'exploitation.

11. Véhicule automobile (10) comprenant au moins un appareil de commande (11) selon l'une des revendications précédentes.
